# EUROPEAN PATENT SPECIFICATION

(11) **EP 3 098 616 B1**
(45) Date of publication and mention of the grant of the patent: **09.05.2018**
(21) Application number: 16170663.5
(22) Date of filing: 20.05.2016
(51) Int. Cl.: G01R 33/09

(54) **MAGNETIC SENSOR**
MAGNETISCHER SENSOR
CAPTEUR MAGNETIQUE

(30) Priority: 22.05.2015 JP 2015104057
(43) Date of publication of application: 30.11.2016
(73) Proprietor: Alps Electric Co., Ltd., Tokyo 145-8501 (JP)
(72) Inventor: Koike, Fumihito, Tokyo, Tokyo 145-8501 (JP); Tokunaga, Ichiro, Tokyo, Tokyo 145-8501 (JP); Okumura, Hirofumi, Tokyo, Tokyo 145-8501 (JP); Yasuda, Yukiko, Tokyo, Tokyo 145-8501 (JP)
(74) Representative: Schmitt-Nilson Schraud Waibel Wohlfrom Patentanwälte Partnerschaft mbB

(56) References cited:
- EP-A2- 2 722 649
- US-A1- 2009 206 827
- US-A1- 2011 163 739
- US-A1- 2012 049 843

## Description

### CLAIM OF PRIORITY

This application claims benefit of Japanese Patent Application No. 2015-104057 filed on May 22, 2015.

### BACKGROUND OF THE INVENTION

### 1. Field of the Invention

The present invention relates to a magnetic sensor having a plurality of magnetoresistive effect elements, and more particularly to a magnetic sensor which outputs two detection values.

### 2. Description of the Related Art

In recent years, a magnetic sensor which uses a magnetic detection element for detecting an external magnetic field has been used to obtain current information, positional information, angle information, and the like, and has been mounted in various electronic devices. Particularly, a magnetic sensor for obtaining angle information is appropriately used in a rotational angle detection device such as a rotation sensor or an angle sensor due to the advantage that measurement can be performed in a non-contact manner.

US 2012/049843 (A1) discloses a sensor and fabrication process for forming reference layers with substantially orthogonal magnetization directions having zero offset with a small compensation angle. An exemplary embodiment includes a sensor layer stack of a magnetoresistive thin-film based magnetic field sensor, the sensor layer stack comprising a pinning layer; a pinned layer including a layer of amorphous material over the pinning layer, and a first layer of crystalline material over the layer of amorphous material; a nonmagnetic coupling layer over the pinned layer; a fixed layer over the nonmagnetic coupling layer; a tunnel barrier over the fixed layer; and a sense layer over the nonmagnetic intermediate layer. Another embodiment includes a sensor layer stack where a pinned layer including two crystalline layers separated by a amorphous layer.

US 2011/163739 A1 provides are a self-pinned spin valve magnetoresistance effect film, a magnetic sensor using the same, and a rotation angle detection device. The self-pinned spin valve magnetoresistance effect film has a strong coupling magnetic field in a pinned layer, a small reduction in the change in resistance, and superior resistance to magnetic fields without reducing the coercive force in a first ferromagnetic layer, which is a pinned layer in the film, even when exposed to a strong external magnetic field. By inserting a non-magnetic layer between a ground layer and a pinned layer to form the spin valve magnetoresistance effect film, the self-pinned spin valve magnetoresistance effect film having superior resistance to magnetic fields, a magnetic sensor using the same, and a rotation angle detection device are obtained.

According to EP 2 722 649 A2 a magnetic encoder includes a magnetic field generating member having different magnetic poles magnetized alternately in a moving direction, multiple magnetic sensors arranged spaced apart from one another in a direction parallel to the moving direction such that the magnetic sensors are not in contact with the magnetic field generating member, and multiple channels provided for each magnetic sensor, each channel including a magnetic detection element having an electrical characteristic varying depending on an external magnetic field from the magnetic field generating member. The single magnetic field generating member enables a phase signal to be generated from each of the magnetic sensors, the phase signals being out of phase, and enables a high resolution signal to be generated based on outputs of the channels such that the high resolution signal includes multiple pulses within a wavelength of each phase signal.

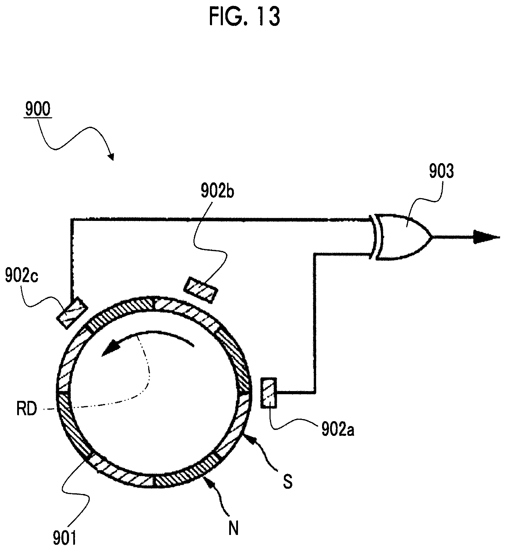

As an example of using a magnetic sensor for a rotational angle detection device, Japanese Unexamined Patent Application Publication No. 2001-201364 (example of the related art) proposes a magnetic encoder 900 (rotational angle detection device) which uses magnetic detection elements (902a, 902b, and 902c) as illustrated in Fig. 13. Fig. 13 is a schematic view illustrating the configuration of the magnetic encoder 900 of the example of the related art.

The magnetic encoder 900 illustrated in Fig. 13 includes a rotating body 901 (in general, a permanent magnet as a magnet body or a permanent magnet provided with a yoke) in which magnetic patterns are arranged to have N-poles and S-poles which appear alternately, the magnetic detection elements (902a, 902b, and 902c) disposed in the vicinity of the rotating body 901, and an EXOR gate 903 which processes signals from the magnetic detection elements (902a and 902c). In addition, the magnetic detection element 902a and the magnetic detection element 902c are disposed to output inverted signals, and using the two signals, a rotational direction RD or a rotational speed of the rotating body 901 is detected. By further disposing the magnetic detection element 902b, an error in the operation of the magnetic encoder 900 or an error in the magnetic patterns of the rotating body 901 can be detected.

However, recently, there has been high demand for a two-output type rotational angle detection device in which an error can be detected and moreover, normal output signals can be obtained even when an error occurs, and there is also a demand for a two-output type magnetic sensor used for the device. Particularly, there is a strong demand for a two-output type in-vehicle rotational angle detection device due to safety standards for vehicles. Regarding the demand for the two-output type device, in a case where the rotating body 901 of the example of the related art in which the magnetic patterns are alternately arranged is used, the two-output type can be easily applied by disposing a pair of magnetic detection elements (magnetic sensors) in the vicinity of the rotating body 901 in advance. However, each of the magnetic detection elements has to be accurately disposed at a predetermined position, and in a case of a slight shift, there is a problem in that it is difficult to obtain the same output information.

On the other hand, recently, there has been a strong demand for a reduction in the size of a rotational angle detection device. However, in a permanent magnet type device in which the magnetic patterns as in the example of the related art have a dense and alternating arrangement, there is a problem in that it is difficult to reduce the size of the magnet body (the rotating body 901 in the example of the related art). In order to solve this problem, using a general permanent magnet having an N-pole and an S-pole, which form a pair, may be considered.

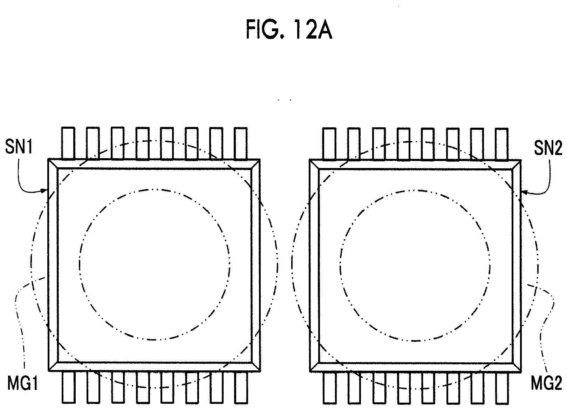

However, in a case of a magnet body which uses a general permanent magnet that is miniaturized, for example, as in Comparative Example 1 illustrated in Fig. 12A, two magnet bodies MG1 and MG2 which respectively correspond to two magnetic sensors SN1 and SN2 have to be used, and there is a problem in that a sufficient reduction in the size of the rotational angle detection device cannot be achieved. Furthermore, since there are slight differences in characteristics between the magnetic sensors (SN1 and SN2) and between the magnet bodies (MG1 and MG2), there is concern that the outputs from the two magnetic sensors SN1 and SN2 may be different from each other depending on the combination of the magnetic sensors (SN1 and SN2) and the magnet bodies (MG1 and MG2).

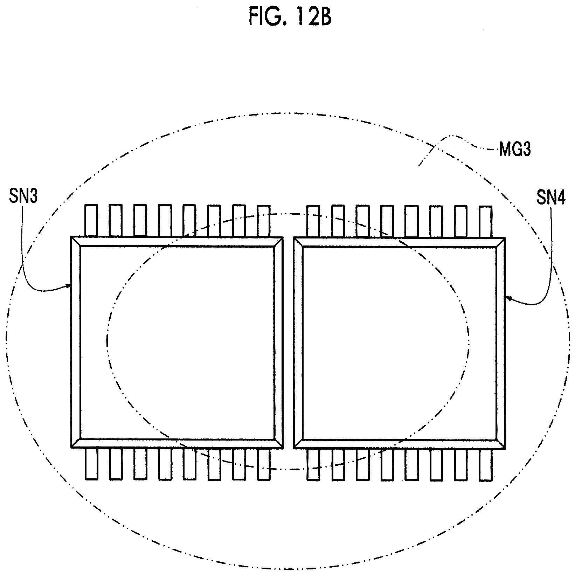

For example, as in Comparative Example 2 illustrated in Fig. 12B, when a single magnet body MG3 corresponds to two magnetic sensors SN3 and SN4, there is a problem in that the size of the magnet body MG3 is increased. Furthermore, there is also similar concern that the outputs from the two magnetic sensors SN3 and SN4 may be different from each other.

### SUMMARY OF THE INVENTION

The present invention provides a magnetic sensor capable of allowing two pieces of output information to be equal to each other.

According to an aspect of the present invention, a magnetic sensor includes: a first magnetic detection element group and a second magnetic detection element group each of which including a plurality of magnetoresistive effect elements each in which a fixed magnetic layer and a free magnetic layer are laminated with a non-magnetic material layer interposed therebetween; and a first control unit and a second control unit configured to respectively process detection signals detected from a magnetic field by the magnetoresistive effect elements of the first magnetic detection element group and the second magnetic detection element group, in which the fixed magnetic layer is of a self-pinned type in which a first magnetic layer and a second magnetic layer are laminated with a non-magnetic intermediate layer interposed therebetween and magnetization directions of the first magnetic layer and the second magnetic layer are fixed to be antiparallel to each other, and pinned magnetization directions of at least two magnetoresistive effect elements in the first magnetic detection element group and the second magnetic detection element group are different from each other, and the plurality of magnetoresistive effect elements of the first magnetic detection element group and the plurality of magnetoresistive effect elements of the second magnetic detection element group are arranged so that the magnetization directions thereof are symmetrical.

Accordingly, in the magnetic sensor according to the aspect of the present invention, the first magnetic detection element group and the second magnetic detection element group are disposed at equivalent positions in the magnetic field generated by a single magnet body. Therefore, a detection value (a first detection value) from the detection signal from the first magnetic detection element group and a detection value (a second detection value) from the detection signal from the second magnetic detection element group can be obtained as equal output values. Moreover, since the magnetoresistive effect elements are of the self-pinned type, the magnetoresistive effect elements of the first magnetic detection element group and the second magnetic detection element group can be manufactured on the same wafer, and two magnetoresistive effect elements having a symmetrical relationship (one is in the first magnetic detection element group and the other is in the second magnetic detection element group) can be formed at the same timing. Therefore, the first detection value and the second detection value can be obtained as equal output values. Accordingly, a magnetic sensor which allows pieces of output information obtained from the two output values to be equal to each other can be provided.

In the magnetic sensor according to the aspect of the present invention, the first magnetic detection element group and the second magnetic detection element group may be formed on a single element substrate, and the plurality of magnetoresistive effect elements of the first magnetic detection element group and the plurality of magnetoresistive effect elements of the second magnetic detection element group may be arranged so that the magnetization directions thereof have point symmetry about a reference point on the element substrate.

Accordingly, even when slight distortion (particularly, there are many cases where distortion occurs in point symmetry) occurs in parallel magnetic fields generated by a general magnet body (a permanent magnet, or a permanent magnet provided with a yoke) having an N-pole and an S-pole, the strengths of magnetic fields received by the two magnetoresistive effect elements having a point symmetrical relationship are the same. Therefore, the detection value (the first detection value) from the first magnetic detection element group and the detection value (the second detection value) from the second magnetic detection element group can be more reliably obtained as equal output values. Furthermore, since the first magnetic detection element group and the second magnetic detection element group are formed on a single element substrate (chip), the two magnetoresistive effect elements having a symmetrical relationship (one is in the first magnetic detection element group and the other is in the second magnetic detection element group) can be disposed at accurately symmetrical positions. Therefore, the first detection value and the second detection value can be more reliably obtained as equal output values.

In the magnetic sensor according to the aspect of the present invention, the first magnetic detection element group, the second magnetic detection element group, the first control unit, and the second control unit may be sealed in a single composite package body, and the first control unit and the second control unit may be disposed with the first magnetic detection element group and the second magnetic detection element group interposed therebetween.

Accordingly, electrical connection (for example, wire bonding) between the first control unit and the first magnetic detection element group and electrical connection between the second control unit and the second magnetic detection element group can be easily and reliably performed. Accordingly, a magnetic sensor having high reliability can be provided.

In the magnetic sensor according to the aspect of the present invention, the first magnetic detection element group and the first control unit may be sealed in a single independent package body, the first magnetic detection element group may include a first sensor body disposed in one end portion of the independent package body, and a second sensor body having the same structure as that of the first sensor body, the first magnetic detection element group sealed in the second sensor body may be the same as the second magnetic detection element group, the first control unit may be the same as the second control unit, one end portion of the first sensor body and one end portion of the second sensor body may be disposed to oppose each other with a reference line interposed therebetween, and the magnetization directions of the plurality of magnetoresistive effect elements of the first magnetic detection element group and the magnetization directions of the plurality of magnetoresistive effect elements of the second magnetic detection element group may be fixed to have line symmetry about the reference line.

Accordingly, by manufacturing sensor bodies (independent package bodies) having a single configuration and inverting the sensor bodies, the sensor bodies can be used as the first sensor body and the second sensor body. Accordingly, the magnetic sensor can be easily manufactured.

In the magnetic sensor according to the aspect of the present invention, a magnetic sensing surface detecting the magnetic fields of the magnetoresistive effect elements in each of the first magnetic detection element group and the second magnetic detection element group may be disposed at a center position in a thickness direction of the independent package body.

Accordingly, simply by disposing the first sensor body and the second sensor body which are inverted to allow the heights in the thickness direction thereof to be aligned with each other, the magnetic sensing surface of the magnetoresistive effect elements of the first magnetic detection element group and the magnetic sensing surface of the magnetoresistive effect elements of the second magnetic detection element group can be formed on the same plane. Accordingly, the magnetic sensor can be easily manufactured.

The magnetic sensor according to the aspect of the present invention may further include a protrusion directed toward the outside in a planar direction from the other end portion of the independent package body.

Accordingly, one end portion in which each of the first magnetic detection element group and the second magnetic detection element group is provided can be reliably recognized. Accordingly, the magnetic sensor can be easily manufactured to allow one end portions thereof to oppose each other without failure.

### BRIEF DESCRIPTION OF THE DRAWINGS

Figs. 1A and 1B are views illustrating a magnetic sensor of a first embodiment of the present invention, Fig. 1A is a plan view of the magnetic sensor, and Fig. 1B is a side view of the magnetic sensor.
Fig. 2 is a view illustrating the magnetic sensor of the first embodiment of the present invention, and is a plan view of the magnetic sensor illustrated in Fig. 1A from which a resin package is removed.
Fig. 3 is a view illustrating an element substrate of the magnetic sensor according to the first embodiment of the present invention, and is a schematic view illustrating a first magnetic detection element group and a second magnetic detection element group.
Fig. 4 is a view illustrating a magnetoresistive effect element of the magnetic sensor according to the first embodiment of the present invention, and is a sectional view of the configuration thereof.
Figs. 5A and 5B are views illustrating the magnetoresistive effect element of the magnetic sensor according to the first embodiment of the present invention, and Figs. 5A and 5B are views illustrating examples of the pattern of the magnetoresistive effect element illustrated in Fig. 3.
Figs. 6A and 6B are circuit diagrams of the magnetoresistive effect elements which are associated with the magnetic sensor of the first embodiment of the present invention and are bridged, Fig. 6A is a bridge circuit of the first magnetic detection element group, and Fig. 6B is a bridge circuit of the second magnetic detection element group.
Figs. 7A and 7B are views illustrating a magnetic sensor of a second embodiment of the present invention, Fig. 7A is a plan view of the magnetic sensor, and Fig. 7B is a side view of the magnetic sensor.
Fig. 8 is a view illustrating the magnetic sensor of the second embodiment of the present invention, and is a plan view of the magnetic sensor illustrated in Fig. 7A from which a resin package is removed.
Fig. 9 is a view illustrating an element substrate of the magnetic sensor according to the second embodiment of the present invention, and is a schematic view illustrating a first magnetic detection element group and a second magnetic detection element group.
Figs. 10A and 10B are views illustrating the magnetic sensor of the second embodiment of the present invention, Fig. 10A is a side view of the magnetic sensor illustrated in Fig. 7B from which the resin package is removed, and Fig. 10B is an enlarged side view of a section P illustrated in Fig. 10A.
Figs. 11A and 11B are circuit diagrams of magnetoresistive effect elements which are associated with the magnetic sensor of the second embodiment of the present invention and are bridged, Fig. 11A is a bridge circuit of a first magnetic detection element group, and Fig. 11B is a bridge circuit of a second magnetic detection element group.
Figs. 12A and 12B are views illustrating comparative examples, Fig. 12A is a schematic view illustrating a magnetic sensor and a magnet body in Comparative Example 1, and Fig. 12B is a schematic view illustrating a magnetic sensor and a magnet body in Comparative Example 2.
Fig. 13 is a schematic view illustrating the configuration of a magnetic encoder of an example of the related art.

### DESCRIPTION OF THE PREFERRED EMBODIMENTS

Hereinafter, embodiments of the present invention will be described with reference to the drawings.

### First Embodiment

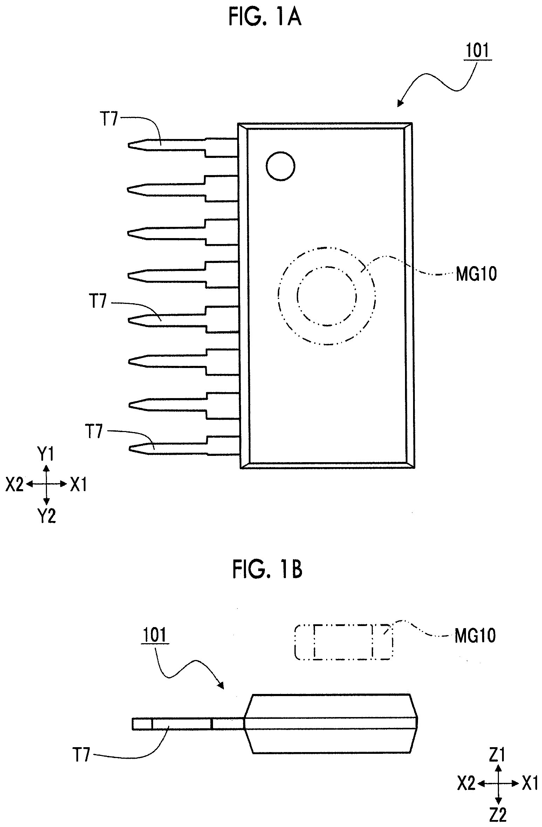

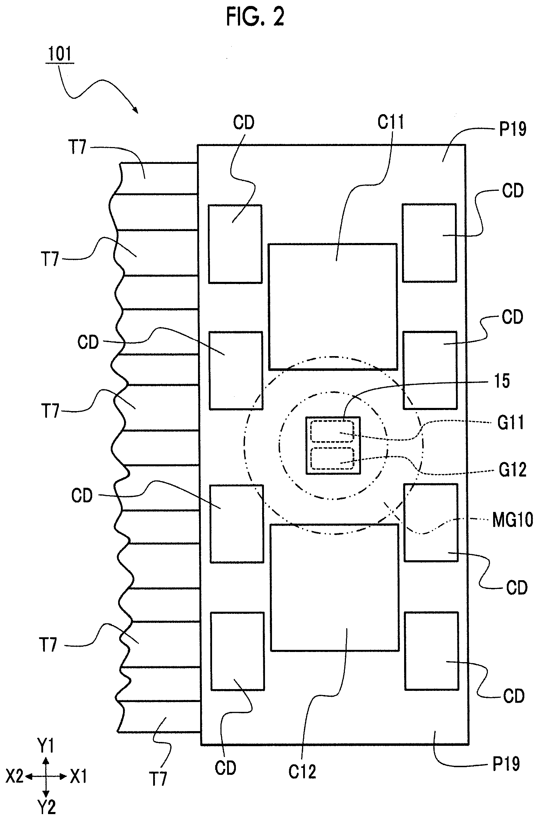

Figs. 1A and 1B are views illustrating a magnetic sensor 101 of a first embodiment of the present invention, Fig. 1A is a plan view of the magnetic sensor 101, and Fig. 1B is a side view of the magnetic sensor 101. Fig. 2 is a view illustrating the magnetic sensor 101 of the first embodiment of the present invention, and is a plan view of the magnetic sensor 101 illustrated in Fig. 1A from which a resin package is removed. In Fig. 2, portions of terminals T7 are omitted. In addition, for easy understanding of the description, in Figs. 1A to 2, the size and position of a magnet body MG10 (a permanent magnet, or a permanent magnet provided with a yoke) when the magnetic sensor 101 is disposed are illustrated.

The magnetic sensor 101 of the first embodiment of the present invention has a single in-line package (SIP) type resin package as illustrated in Figs. 1A and 1B, and as illustrated in Fig. 2, includes an element substrate 15 in which a first magnetic detection element group G11 and a second magnetic detection element group G12 are formed, and a first control unit C11 and a second control unit C12 which respectively process detection signals from the first magnetic detection element group G11 and the second magnetic detection element group G12. Furthermore, in the first embodiment of the present invention, the magnetic sensor 101 includes eight capacitors CD, a circuit board P19 on which the capacitors CD, the element substrate 15, and the like are mounted, and the terminals T7 for connection to an external device.

The magnetic sensor 101 detects a change in the magnetic field generated by the magnet body MG10 having a ring shape and processes and outputs a detected detection signal. Specifically, for example, when the magnetic sensor 101 is applied to a rotational angle detection device, a magnetic field is changed by the magnet body MG10 as the magnet body MG10 provided in the rotational angle detection device rotates together with a rotation detection target of which the rotational angle is to be detected, a change in the magnetic field is detected by the magnetic sensor 101, and a detected detection signal is processed and is output to the rotational angle detection device as an output signal. The magnetic sensor 101 is a so-called two-output type sensor in which the detection signal detected by the first magnetic detection element group G11 is processed by the first control unit C11 and can be output as a detection value (first detection value) and the detection signal detected by the second magnetic detection element group G12 is processed by the second control unit C12 and can be output as a detection value (second detection value).

In addition, in the first embodiment of the present invention, in the magnetic sensor 101, the first magnetic detection element group G11, the second magnetic detection element group G12, the first control unit C11, and the second control unit C12 are sealed in a single composite package body as illustrated in Figs. 1A and 1B. Furthermore, as illustrated in Fig. 2, the first control unit C11 and the second control unit C12 are disposed with the first magnetic detection element group G11 and the second magnetic detection element group G12 (the element substrate 15) interposed therebetween. That is, the first control unit C11 and the first magnetic detection element group G11 are disposed adjacent to each other, and the second control unit C12 and the second magnetic detection element group G12 are disposed adjacent to each other.

Accordingly, electrical connection (for example, connection through wire bonds) between the first control unit C11 and the first magnetic detection element group G11 and electrical connection between the second control unit C12 and the second magnetic detection element group G12 can be easily and reliably performed. Accordingly, the magnetic sensor 101 having high reliability can be provided.

Furthermore, in this arrangement, as illustrated in Fig. 2, the first magnetic detection element group G11 and the second magnetic detection element group G12 can be disposed close to each other, and the first magnetic detection element group G11 and the second magnetic detection element group G12 can be disposed at the center of the composite package body. Therefore, even regarding the magnet body MG10 having a small size, the first magnetic detection element group G11 and the second magnetic detection element group G12 can be disposed at a position that opposes the center portion of the magnet body MG10 having a ring shape, and thus the magnetic sensor 101 can detect a change in magnetic field at a desired position in the magnetic field. Accordingly, the magnetic sensor 101 can contribute to the use of the magnet body MG10 having a small size for a rotation detection device.

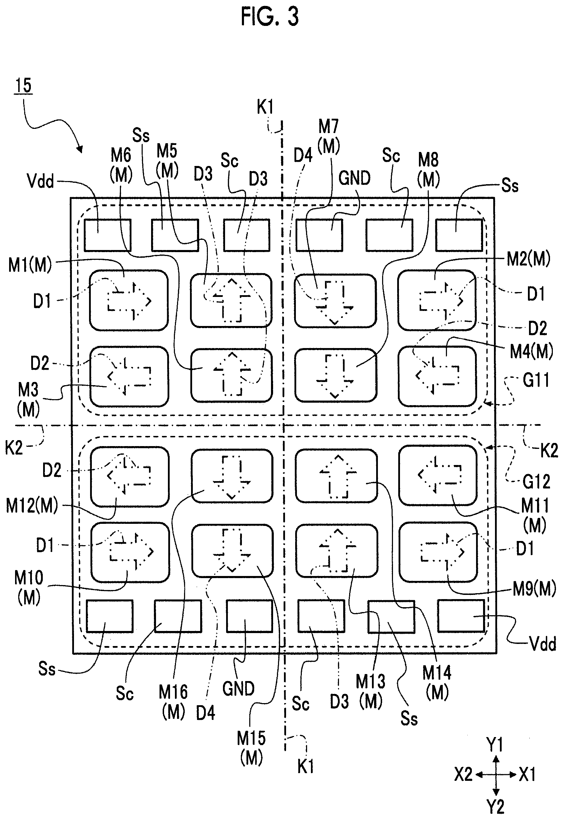

Next, each constituent element will be described. First, the element substrate 15 of the magnetic sensor 101 will be described. Fig. 3 is a view illustrating the element substrate 15 and is a schematic view illustrating the first magnetic detection element group G11 and the second magnetic detection element group G12 each of which includes a plurality of (specifically, eight) magnetoresistive effect elements M. In Fig. 3, detailed patterns of each of the magnetoresistive effect elements M are omitted, and only a region in which patterns are formed is illustrated. In addition, in each of the magnetoresistive effect elements M, the magnetization direction is indicated by an arrow. In Fig. 3, the pad of a source Vdd, the pad of a ground GND, and the pads of output signals Sc and output signals Ss are illustrated. In addition, in Fig. 3, for easy understanding of description, wiring patterns that electrically connect the magnetoresistive effect elements M are omitted.

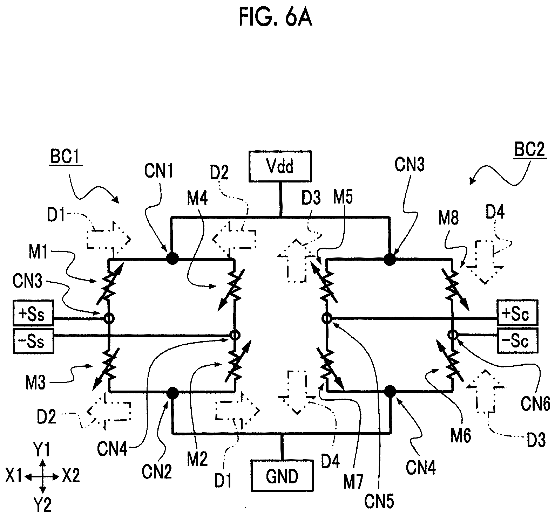

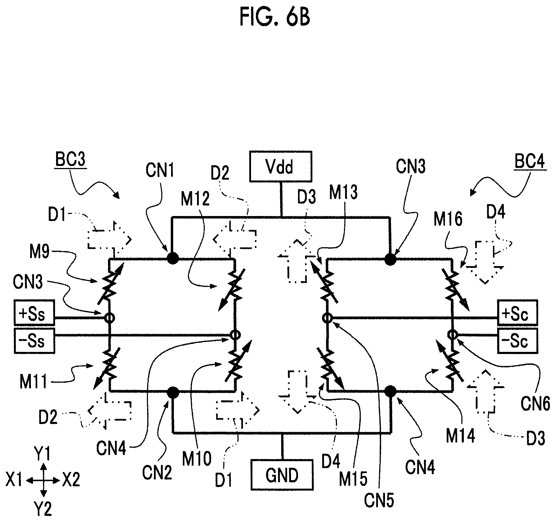

The element substrate 15 of the magnetic sensor 101 is manufactured by using a base substrate made of silicon or the like, and as illustrated in Fig. 3, the first magnetic detection element group G11 provided with the eight (M1 to M8) magnetoresistive effect elements and the second magnetic detection element group G12 provided with the eight (M9 to M16) magnetoresistive effect elements M are formed on the same plane. In addition, each of the first magnetic detection element group G11 and the second magnetic detection element group G12 forms a bridge circuit (see Figs. 6A and 6B), which will be described later, by connecting the eight magnetoresistive effect elements M through the wiring patterns (not illustrated).

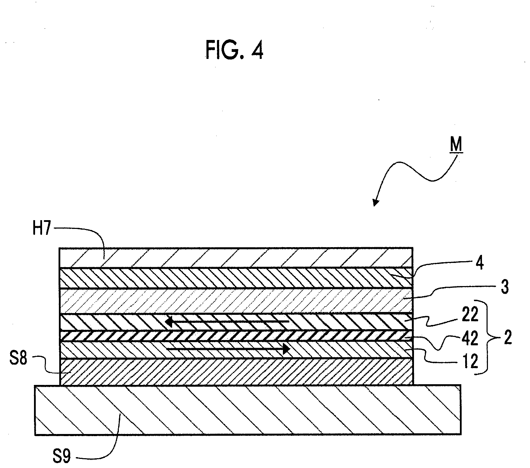

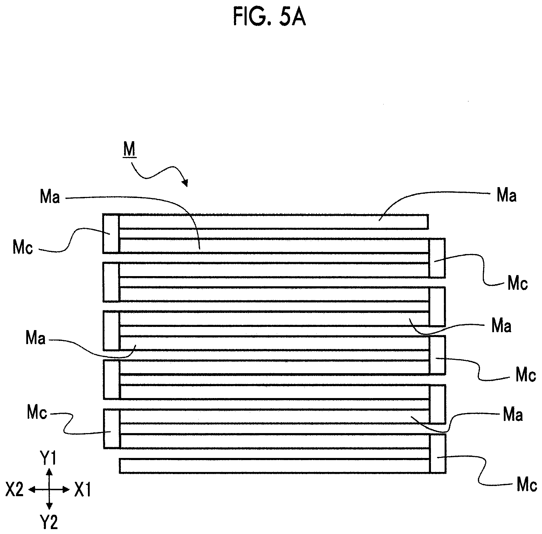

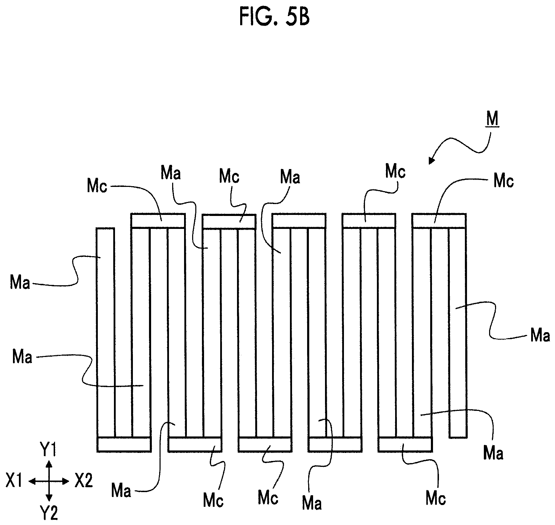

Here, the magnetoresistive effect elements M in the first magnetic detection element group G11 and the second magnetic detection element group G12 formed in the element substrate 15 are simply described first. Fig. 4 is a sectional view of the configuration of the magnetoresistive effect element M. Figs. 5A and 5B are views illustrating the magnetoresistive effect element M, and Figs. 5A and 5B are views illustrating examples of the pattern of the magnetoresistive effect element M illustrated in Fig. 3.

As illustrated in Fig. 4, the magnetoresistive effect element M is formed by sequentially laminating, on a substrate S9 made of silicon or the like (a portion divided from the base substrate), via a seed layer S8 formed of NiFeCr (nickel iron chromium), Cr (chromium), or the like, a fixed magnetic layer 2 of which the magnetization direction is pinned along a certain direction, a non-magnetic material layer 3, a free magnetic layer 4 of which the magnetization direction is rotated along the direction of an external magnetic field, and a protective layer H7. Each of the layers constituting the magnetoresistive effect element M is formed by, for example, sputtering.

As illustrated in Fig. 5A, a single magnetoresistive effect element M has a meandering pattern in which a plurality of element portions Ma that extend long in a band shape in an X direction are patterned with intervals therebetween in a Y direction and X1 side end portions and X2 side end portions of the element portions Ma are alternately connected by conductive portions Mc. In addition, as illustrated in Fig. 5B, another single magnetoresistive effect element M has a meandering pattern in which a plurality of element portions Ma that extend long in a band shape in the Y direction are patterned with intervals therebetween in the X direction and are connected by conductive portions Mc in the same manner. The first magnetic detection element group G11 and the second magnetic detection element group G12 are formed by a combination of the magnetoresistive effect elements M having the two patterns. The conductive portion Mc may be either non-magnetic or magnetic and preferably has low electrical resistance.

As illustrated in Fig. 4, the fixed magnetic layer 2 of the magnetoresistive effect element M has a synthetic ferri pinned (SFP) structure in which a first magnetic layer 12 and a second magnetic layer 22 are laminated with a non-magnetic intermediate layer 42 interposed therebetween. The fixed magnetization direction (arrow shown in Fig. 4) of the first magnetic layer 12 and the fixed magnetization direction (arrow shown in Fig. 4) of the second magnetic layer 22 are fixed to be antiparallel to each other. Due to the SFP structure, a so-called self-pinned magnetoresistive effect element M is achieved. In addition, the non-magnetic material layer 3 of the magnetoresistive effect element M uses a non-magnetic conductive material such as copper (Cu), and the free magnetic layer 4 uses a soft magnetic material such as NiFe (nickel iron), CoFe (cobalt iron), or CoFeNi (cobalt iron nickel) and is configured to have a single-layer structure or a laminated structure of the materials. The protective layer H7 uses tantalum (Ta) or the like.

In the magnetoresistive effect element M configured as described above, since the fixed magnetic layer 2 is formed to have the self-pinned structure illustrated in Fig. 4, an annealing treatment in a magnetic field becomes unnecessary. Therefore, the magnetization direction can be oriented along an arbitrary direction by applying a magnetic field during film formation. Accordingly, through a plurality of film formation operations, a plurality of magnetoresistive effect elements M having different magnetization directions can be formed on the same substrate (the element substrate 15). In the self-pinned structure, the fixed magnetization direction of the fixed magnetic layer 2 that is formed in advance does not change once the magnetization is fixed due to the Ruderman-Kittel-Kasuya-Yosida (RKKY) interaction that strongly occurs between the first magnetic layer 12 and the second magnetic layer 22 even during film formation of the fixed magnetic layer 2 of the subsequent magnetoresistive effect element M in a magnetic field. In addition, the sensitivity axis direction of the magnetoresistive effect element M is coincident with the magnetization direction of the fixed magnetic layer 2 (the second magnetic layer 22).

The first magnetic detection element group G11 and the second magnetic detection element group G12 are configured by using the self-pinned magnetoresistive effect elements M described above. As illustrated in Fig. 3, the first magnetic detection element group G11 and the second magnetic detection element group G12 are configured by combining the magnetoresistive effect elements M having four different magnetization directions (the pinned magnetization direction of the fixed magnetic layer 2 or the sensitivity axis direction). In addition, in the first embodiment of the present invention, as illustrated in Fig. 3, the four different magnetization directions include a first direction D1 (X1 direction) and a second direction D2 (X2 direction), which are opposite to each other in an X-axis direction, and a third direction D3 (Y1 direction) and a fourth direction D4 (Y2 direction), which are opposite to each other in a Y-axis direction perpendicular to the X-axis direction.

In addition, the magnetization directions of the magnetoresistive effect elements M in the first magnetic detection element group G11 and the second magnetic detection element group G12 are divided into combinations each of which includes four different magnetization directions as a set by a first virtual line K1 parallel to the Y-axis direction.

Furthermore, as illustrated in Fig. 3, the first magnetic detection element group G11 and the second magnetic detection element group G12 are configured to be disposed so that the magnetization directions (the first direction D1, the second direction D2, the third direction D3, and the fourth direction D4) have line symmetry about a second virtual line K2 that is parallel to the X-axis direction (perpendicular to the first virtual line K1) and passes between the first magnetic detection element group G11 and the second magnetic detection element group G12. Accordingly, by disposing the magnet body MG10 to allow the center line of the single magnet body MG10 to be coincident with the second virtual line K2, the first magnetic detection element group G11 and the second magnetic detection element group G12 are disposed at equivalent positions in left and right magnetic fields generated by the magnet body MG10. Therefore, the detection value (the first detection value) from the detection signal from the first magnetic detection element group G11 and the detection value (the second detection value) from the detection signal from the second magnetic detection element group G12 can be obtained as equal output values.

Moreover, since the magnetoresistive effect elements M are of the self-pinned type, the magnetoresistive effect elements M of the first magnetic detection element group G11 and the second magnetic detection element group G12 can be manufactured on the same wafer, and two magnetoresistive effect elements M having a symmetrical relationship (one is in the first magnetic detection element group G11 and the other is in the second magnetic detection element group G12) can be formed at the same timing. Therefore, the first detection value and the second detection value can be obtained as equal output values.

Furthermore, in the first embodiment of the present invention, as illustrated in Fig. 3, the plurality of (eight) magnetoresistive effect elements M of the first magnetic detection element group G11 and the plurality of (eight) magnetoresistive effect elements M of the second magnetic detection element group G12 are arranged so that the magnetization directions thereof have point symmetry about a reference point (in Fig. 3, the point of intersection between the first virtual line K1 and the second virtual line K2). Specifically, each of the magnetoresistive effect elements M1 and M9, the magnetoresistive effect elements M2 and M10, the magnetoresistive effect elements M3 and M11, the magnetoresistive effect elements M4 and M12, the magnetoresistive effect elements M5 and M13, the magnetoresistive effect elements M6 and M14, the magnetoresistive effect elements M7 and M15, the magnetoresistive effect elements M8 and M16 are disposed so that the magnetization directions thereof have point symmetry about the reference point. Accordingly, even when slight distortion occurs in parallel magnetic fields generated by the general magnet body MG10 having the N-pole and the S-pole, the strengths of magnetic fields received by the two magnetoresistive effect elements M having a point symmetrical relationship are the same. Therefore, the detection value (the first detection value) from the first magnetic detection element group G11 and the detection value (the second detection value) from the second magnetic detection element group G12 can be more reliably obtained as equal output values. Particularly, in the case of the magnet body MG10 having a ring shape, the magnetic flux is likely to undergo distortion in point symmetry, and thus higher effectiveness is achieved.

In addition, in the first embodiment of the present invention, since the first magnetic detection element group G11 and the second magnetic detection element group G12 are formed on the single element substrate 15 (chip), the two magnetoresistive effect elements having a symmetrical relationship (one is in the first magnetic detection element group G11 and the other is in the second magnetic detection element group G12) can be disposed at accurately symmetrical positions. Therefore, the first detection value and the second detection value can be more reliably obtained as equal output values. In addition, since a single chip is used, an effect of facilitating manufacturing is exhibited.

Furthermore, the first magnetic detection element group G11 and the second magnetic detection element group G12 can be disposed close to each other, and be disposed at the center position of the magnet body MG10 for generating the magnetic fields, the magnet body MG10 having a smaller size can be used.

Here, regarding the first magnetic detection element group G11 and the second magnetic detection element group G12 formed in the element substrate 15, bridge circuits will be described. Figs. 6A and 6B are circuit diagrams of the magnetoresistive effect elements M which are associated with the magnetic sensor 101 of the first embodiment of the present invention and are bridged, Fig. 6A is a bridge circuit of the first magnetic detection element group G11, and Fig. 6B is a bridge circuit of the second magnetic detection element group G12. In Figs. 6A and 6B, the sensitivity axis direction (magnetization direction) of each of the magnetoresistive effect elements M is illustrated.

As illustrated in Fig. 6A, the bridge circuit of the first magnetic detection element group G11 is configured to have a first bridge circuit BC1 using the four magnetoresistive effect elements M (M1, M2, M3, and M4) and a second bridge circuit BC2 using the four magnetoresistive effect elements M (M5, M6, M7, and M8).

As illustrated in Fig. 6B, the bridge circuit of the second magnetic detection element group G12 is configured to have a third bridge circuit BC3 using the four magnetoresistive effect elements M (M9, M10, M11, and M12) and a fourth bridge circuit BC4 using the four magnetoresistive effect elements M (M13, M14, M15, and M16).

First, as illustrated in Fig. 6A, the first bridge circuit BC1 is constituted by the magnetoresistive effect element M1 pinned along the first direction D1 (the X1 direction shown in Fig. 3), the magnetoresistive effect element M2 pinned along the first direction D1, the magnetoresistive effect element M3 pinned along the second direction D2 (the X2 direction shown in Fig. 3), and the magnetoresistive effect element M4 pinned along the second direction D2. That is, as illustrated in Fig. 3, the sensitivity axis direction (the first direction D1) of the magnetoresistive effect elements M1 and M2 and the sensitivity axis direction (the second direction D2) of the magnetoresistive effect elements M3 and M4 are antiparallel to each other. In addition, the four magnetoresistive effect elements M use the pattern illustrated in Fig. 5A.

As illustrated in Fig. 6A, a first connection portion CN1 is formed by connecting one end of the magnetoresistive effect element M1 and one end of the magnetoresistive effect element M4, a second connection portion CN2 is formed by connecting one end of the magnetoresistive effect element M2 and one end of the magnetoresistive effect element M3, a third connection portion CN3 is formed by connecting the other end of the magnetoresistive effect element M1 and the other end of the magnetoresistive effect element M3, and a fourth connection portion CN4 is formed by connecting the other end of the magnetoresistive effect element M4 and the other end of the magnetoresistive effect element M2. In the first bridge circuit BC1 configured as described above, a predetermined potential difference is established between the first connection portion CN1 and the second connection portion CN2 (between the source Vdd and the ground GND), and two outputs (output signals Ss having inverted sine waves) corresponding to changes in temperature and external magnetic field are obtained by the third connection portion CN3 and the fourth connection portion CN4.

Next, as illustrated in Fig. 6A, the second bridge circuit BC2 is constituted by the magnetoresistive effect element M5 pinned along the third direction D3 (the Y1 direction shown in Fig. 3), the magnetoresistive effect element M6 pinned along the third direction D3, the magnetoresistive effect element M7 pinned along the fourth direction D4 (the Y2 direction shown in Fig. 3), and the magnetoresistive effect element M8 pinned along the fourth direction D4. That is, as illustrated in Fig. 3, the sensitivity axis direction (the third direction D3) of the magnetoresistive effect elements M5 and M6 and the sensitivity axis direction (the fourth direction D4) of the magnetoresistive effect elements M7 and M8 are antiparallel to each other. In addition, the four magnetoresistive effect elements M use the pattern illustrated in Fig. 5B.

As illustrated in Fig. 6A, a third connection portion CN3 is formed by connecting one end of the magnetoresistive effect element M5 and one end of the magnetoresistive effect element M8, a fourth connection portion CN4 is formed by connecting one end of the magnetoresistive effect element M6 and one end of the magnetoresistive effect element M7, a fifth connection portion CN5 is formed by connecting the other end of the magnetoresistive effect element M5 and the other end of the magnetoresistive effect element M7, and a sixth connection portion CN6 is formed by connecting the other end of the magnetoresistive effect element M8 and the other end of the magnetoresistive effect element M6. In the second bridge circuit BC2 configured as described above, a predetermined potential difference is established between the third connection portion CN3 and the fourth connection portion CN4 (between the source Vdd and the ground GND), and two outputs (output signals Ss having inverted cosine waves) corresponding to changes in temperature and external magnetic field are obtained by the fifth connection portion CN5 and the sixth connection portion CN6.

The output values from the first magnetic detection element group G11 having the first and second bridge circuits BC1 and BC2 configured as described above are four output values which are out of phase with each other and have different waveforms, and the four output values are transmitted to the first control unit C11. The first and second bridge circuits BC1 and BC2 are generally well-known bridge circuits, and thus the detailed description of changes in an external magnetic field and output waves will be omitted.

On the other hand, the third and fourth bridge circuits BC3 and BC4 of the second magnetic detection element group G12 are configured to be the same as the first and second bridge circuits BC1 and BC2 of the first magnetic detection element group G11, respectively, and the magnetoresistive effect elements M in the first and second bridge circuits BC1 and BC2 are substituted with the magnetoresistive effect elements M in point symmetry. That is, as illustrated in Fig. 6B, the magnetoresistive effect element M1 is substituted with the magnetoresistive effect element M9, the magnetoresistive effect element M2 is substituted with the magnetoresistive effect element M10, the magnetoresistive effect element M3 is substituted with the magnetoresistive effect element M11, the magnetoresistive effect element M4 is substituted with the magnetoresistive effect element M12, the magnetoresistive effect element M5 is substituted with the magnetoresistive effect element M13, the magnetoresistive effect element M6 is substituted with the magnetoresistive effect element M14, the magnetoresistive effect element M7 is substituted with the magnetoresistive effect element M15, and the magnetoresistive effect element M8 is substituted with the magnetoresistive effect element M16.

Accordingly, the output values from the second magnetic detection element group G12 having the third and fourth bridge circuits BC3 and BC4 are four output values which are out of phase with each other and have different waveforms like the output values from the first magnetic detection element group G11, and furthermore, equal output values are transmitted to the second control unit C12. Therefore, even in a case where any of the system of the first magnetic detection element group G11 and the system of the second magnetic detection element group G12 has a problem, the magnetic sensor 101 can provide accurate output information to an external device.

Next, the first control unit C11 and the second control unit C12 of the magnetic sensor 101 will be described. The first control unit C11 and the second control unit C12 are configured by using an integrated circuit (IC) and process the detection signals from the first magnetic detection element group G11 and the second magnetic detection element group G12. In addition, the first control unit C11 and the second control unit C12 output the processed information to the rotational angle detection device as output signals (output information) via the terminals T7.

In the first embodiment of the present invention, the two first and second control units C11 and C12 are separately provided as two chips. Therefore, for example, even when any one of the first and second control units C11 and C12 has a problem, the other can output an output signal. Accordingly, the magnetic sensor 101 having high reliability can be provided.

Last, the circuit board P19 and the terminals T7 of the magnetic sensor 101 will be described. First, the circuit board P19 of the magnetic sensor 101 uses a double-sided printed wiring board (PWB) which is generally used. As illustrated in Fig. 2, the capacitors CD, the element substrate 15, the first control unit C11, and the second control unit C12 are mounted on one side of the circuit board P19, and the terminals T7 are mounted on the other side of the circuit board P19. In Fig. 2, detailed wiring patterns are omitted.

Next, a metallic thin plate is cut and plated with nickel or the like to be used as the terminal T7 of the magnetic sensor 101, and the eight terminals T7 are provided. In addition, the output signals processed by the first control unit C11 are output from the four terminals T7 on one side, and the output signals processed by the second control unit C12 are output from the four terminals T7 on the other side.

The effects of the magnetic sensor 101 of the first embodiment of the present invention configured as described above will be described below in summary.

The magnetic sensor 101 of the first embodiment of the present invention includes the first magnetic detection element group G11 and the second magnetic detection element group G12 each of which includes the plurality of magnetoresistive effect elements M, and the plurality of magnetoresistive effect elements M of the first magnetic detection element group G11 and the plurality of magnetoresistive effect elements M of the second magnetic detection element group G12 are arranged so that the pinned magnetization directions thereof are symmetrical. Accordingly, the first magnetic detection element group G11 and the second magnetic detection element group G12 are disposed at equivalent positions in the magnetic field generated by the magnet body MG10. Therefore, the detection value (the first detection value) from the detection signal from the first magnetic detection element group G11 and the detection value (the second detection value) from the detection signal from the second magnetic detection element group G12 can be obtained as equal output values . Moreover, since the magnetoresistive effect elements M are of the self-pinned type, the magnetoresistive effect elements M of the first magnetic detection element group G11 and the second magnetic detection element group G12 can be manufactured on the same wafer, and two magnetoresistive effect elements M having a symmetrical relationship (one is in the first magnetic detection element group G11 and the other is in the second magnetic detection element group G12) can be formed at the same timing. Therefore, the first detection value and the second detection value can be obtained as equal output values. Accordingly, the magnetic sensor 101 which allows pieces of output information obtained from the two output values to be equal to each other can be provided.

In addition, the plurality of magnetoresistive effect elements M of the first magnetic detection element group G11 and the plurality of magnetoresistive effect elements M of the second magnetic detection element group G12 are arranged so that the magnetization directions thereof have point symmetry. Accordingly, even when slight distortion (particularly, there are many cases where distortion occurs in point symmetry) occurs in parallel magnetic fields generated by the general magnet body MG10 having the N-pole and the S-pole, the strengths of magnetic fields received by the two magnetoresistive effect elements M having a point symmetrical relationship are the same. Therefore, the detection value (the first detection value) from the first magnetic detection element group G11 and the detection value (the second detection value) from the second magnetic detection element group G12 can be more reliably obtained as equal output values. Furthermore, since the first magnetic detection element group G11 and the second magnetic detection element group G12 are formed on the single element substrate 15 (chip), the two magnetoresistive effect elements M having a symmetrical relationship (one is in the first magnetic detection element group G11 and the other is in the second magnetic detection element group G12) can be disposed at accurately symmetrical positions. Therefore, the first detection value and the second detection value can be more reliably obtained as equal output values. Accordingly, the magnetic sensor 101 which allows pieces of output information obtained from the two output values to be equal to each other can be provided.

In addition, since the first control unit C11 and the second control unit C12 are disposed with the first magnetic detection element group G11 and the second magnetic detection element group G12 interposed therebetween, and are sealed in a single composite package body, electrical connection (for example, connection through wire bonds) between the first control unit C11 and the first magnetic detection element group G11 and electrical connection between the second control unit C12 and the second magnetic detection element group G12 can be easily and reliably performed. Accordingly, the magnetic sensor 101 having high reliability can be provided.

### Second Embodiment

A magnetic sensor 102 of a second embodiment of the present invention has a configuration in which two independent package bodies are combined, which is from the configuration of the single composite package body in the magnetic sensor 101 of the first embodiment. Like elements similar to those of the first embodiment are denoted by like reference numerals, and detailed description thereof will be omitted.

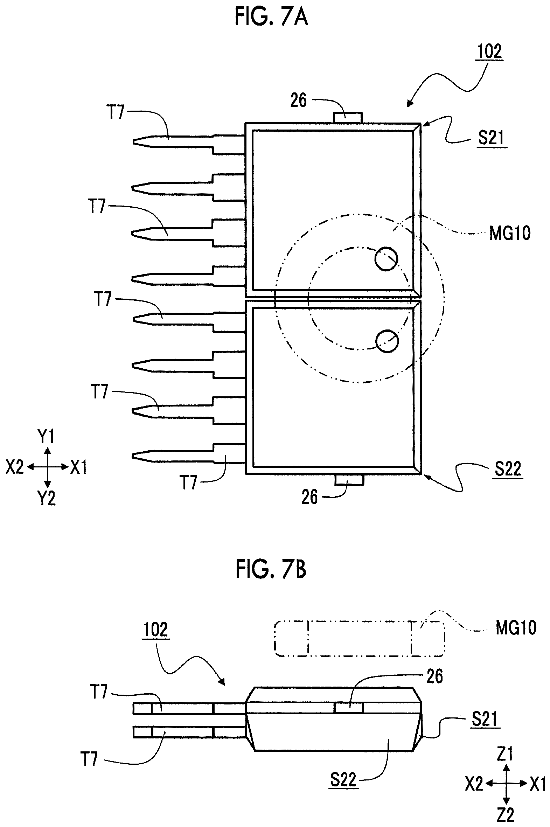

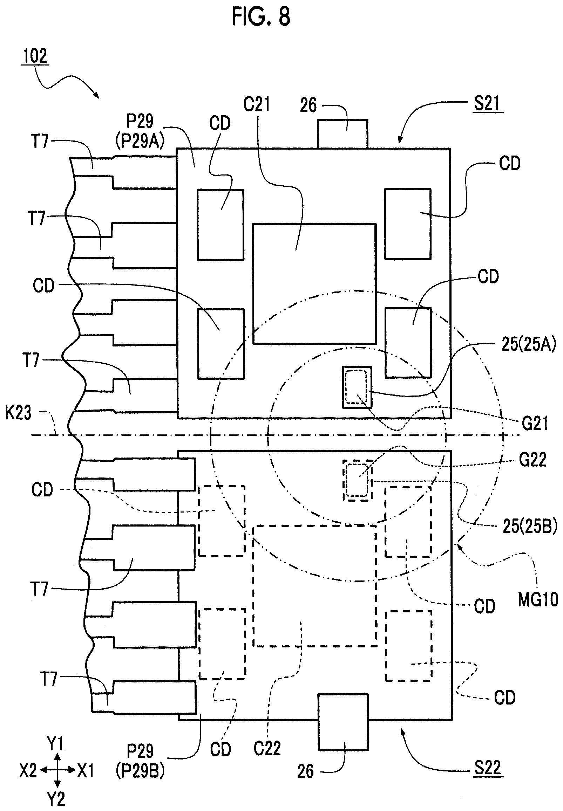

Figs. 7A and 7B are views illustrating the magnetic sensor 102 of the second embodiment of the present invention, Fig. 7A is a plan view of the magnetic sensor 102, and Fig. 7B is a side view of the magnetic sensor 102. Fig. 8 is a view illustrating the magnetic sensor 102 of the second embodiment of the present invention, and is a plan view of the magnetic sensor 102 illustrated in Fig. 7A from which a resin package is removed. In Fig. 8, portions of the terminals T7 are omitted. In addition, for easy understanding of the description, in Figs. 7A to 8, the size and position of the magnet body MG10 (a permanent magnet, or a permanent magnet provided with a yoke) when the magnetic sensor 102 is disposed are illustrated.

The magnetic sensor 102 of the second embodiment of the present invention has a single in-line package (SIP) type resin package as illustrated in Figs. 7A and 7B, and is configured by combining a first sensor body S21, which is an independent package body, and a second sensor body S22 having the same structure as that of the first sensor body S21. In addition, as illustrated in Fig. 8, a first magnetic detection element group G21 and a first control unit C21 are sealed in the first sensor body S21, and a second magnetic detection element group G22 and a second control unit C22 are sealed in the second sensor body S22.

Particularly, in the magnetic sensor 102 of the second embodiment of the present invention, the first sensor body S21 and the second sensor body S22 independently uses the same package body and are configured so that one thereof is inverted to be lined up. That is, in the magnetic sensor 102, the first magnetic detection element group G21 of the first sensor body S21 is the same as the second magnetic detection element group G22 of the second sensor body S22, and the first control unit C21 of the first sensor body S21 is the same as the second control unit C22 of the second sensor body S22 . Accordingly, by manufacturing the sensor bodies (independent package bodies) having a single configuration, the sensor bodies can be used as the first sensor body S21 and the second sensor body S22 . Accordingly, the magnetic sensor 102 can be easily manufactured.

In addition, in the magnetic sensor 102 of the second embodiment of the present invention, the SIP type package is appropriately used. Therefore, when the two sensor bodies (the first and second sensor bodies S21 and S22) are inverted to be arranged in parallel, the heights thereof in the thickness direction can be appropriately aligned with each other without the terminals T7 interfering with each other. By using two independent package bodies (sensor bodies) that are manufactured, the package bodies can be applied to the magnetic sensor 102 of a two-output type, or may also be used as a single-output type magnetic sensor.

As illustrated in Fig. 8, the magnetic sensor 102 in which the two independent package bodies are combined is configured to include element substrates 25 in which the first magnetic detection element group G21 and the second magnetic detection element group G22 are formed, and the first control unit C21 and the second control unit C22 which respectively process detection signals from the first magnetic detection element group G21 and the second magnetic detection element group G22. Furthermore, in the second embodiment of the present invention, the magnetic sensor 102 includes eight capacitors CD, circuit boards P29 on which the capacitors CD, the element substrate 25, and the like are mounted, and the terminals T7 for connection to an external device. At this time, the element substrate 25 (referred to as an element substrate 25A for easy understanding of description) in which the first magnetic detection element group G21 is formed is disposed in one (in the Y2 direction shown in Fig. 8) end portion of the circuit board P29 (referred to as a circuit board P29A for easy understanding of description) of the independent package body (the first sensor body S21), and the element substrate 25 (referred to as an element substrate 25B for easy understanding of description) in which the second magnetic detection element group G22 is formed is disposed in one (in the Y1 direction shown in Fig. 8) end portion of the circuit board P29 (referred to as a circuit board P29B for easy understanding of description) of the independent package body (the second sensor body S22) .

The magnetic sensor 102 includes a protrusion 26 which is directed toward the outside in a planar direction from the other end portion (the side opposite to the one side on which the element substrate 25 is disposed) of the independent package body. Accordingly, one end portion of the circuit board P29 in which each of the first magnetic detection element group G21 and the second magnetic detection element group G22 is provided can be reliably recognized. Accordingly, when the magnetic sensor 102 is manufactured, one end portions thereof can be allowed to oppose each other without failure. In addition, the protrusion 26 is formed simultaneously with the terminals T7 which is manufactured by cutting a metallic thin plate and thus can be easily manufactured.

The magnetic sensor 102 of the second embodiment of the present invention detects a change in the magnetic field generated by the magnet body MG10 having a ring shape and processes and outputs a detected detection signal. Specifically, for example, when the magnetic sensor 102 is applied to a rotational angle detection device, a magnetic field of is changed by the magnet body MG10 as the magnet body MG10 provided in the rotational angle detection device rotates together with a rotation detection target of which the rotational angle is to be detected, a change in the magnetic field is detected by the magnetic sensor 102, and a detected detection signal is processed and is output to the rotational angle detection device as an output signal. Similar to the magnetic sensor 101 of the first embodiment, the magnetic sensor 102 is a so-called two-output type sensor in which the detection signal detected by the first magnetic detection element group G21 is processed by the first control unit C21 and can be output as a detection value (first detection value) and the detection signal detected by the second magnetic detection element group G22 is processed by the second control unit C22 and can be output as a detection value (second detection value).

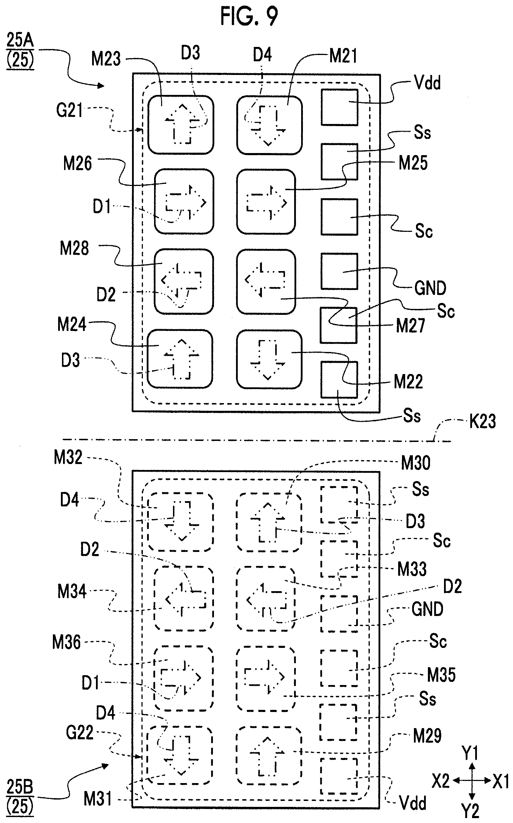

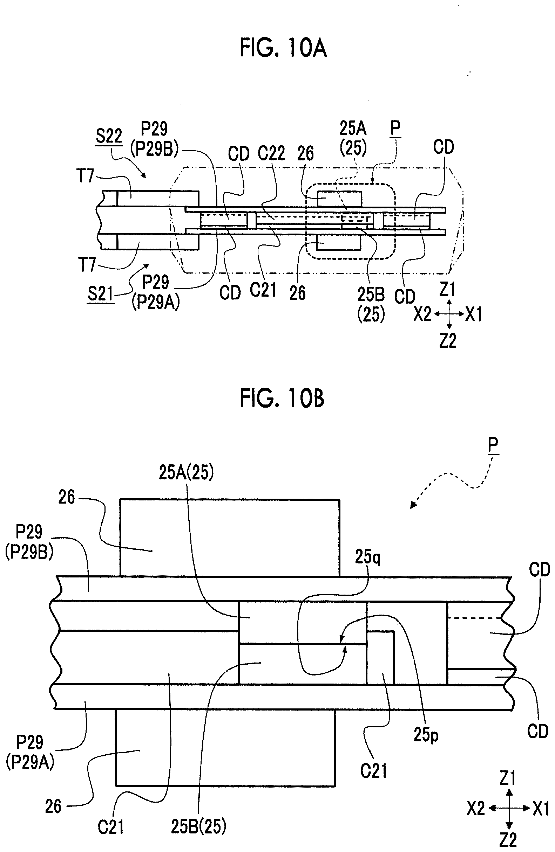

Next, each constituent element will be described. First, the element substrate 25 of the magnetic sensor 102 will be described. Fig. 9 is a view illustrating the element substrate 25 and is a schematic view illustrating the first magnetic detection element group G21 and the second magnetic detection element group G22 each of which includes a plurality of (specifically, eight) magnetoresistive effect elements M. In Fig. 9, detailed patterns of each of the magnetoresistive effect elements M are omitted, and only a region in which patterns are formed is illustrated. In addition, in each of the magnetoresistive effect elements M, the magnetization direction is indicated by an arrow. In Fig. 9, the pad of a source Vdd, the pad of a ground GND, and the pads of output signals Sc and output signals Ss are illustrated. In addition, in Fig. 9, for easy understanding of description, wiring patterns that electrically connect the magnetoresistive effect elements M are omitted. Fig. 10A is a side view of the magnetic sensor 102 illustrated in Fig. 7B from which the resin package is removed, and Fig. 10B is an enlarged side view of a section P illustrated in Fig. 10A. In Fig. 10A, portions of the terminals T7 are omitted, and the external part of the resin package is indicated by two-dot chain line. In addition, in Fig. 10B, for easy understanding of description, the second control unit C22 shown on the front side of the Fig. 10B is omitted.

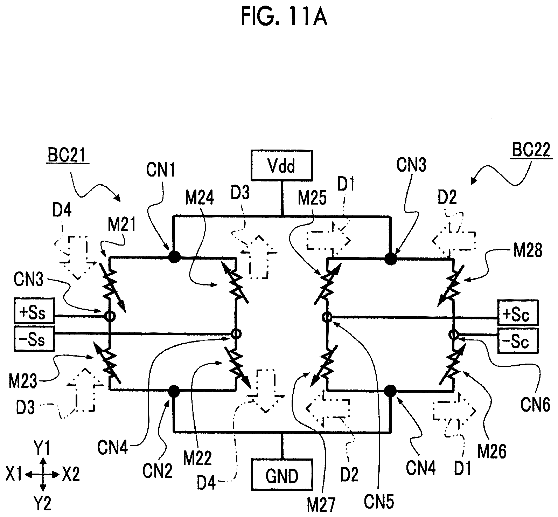

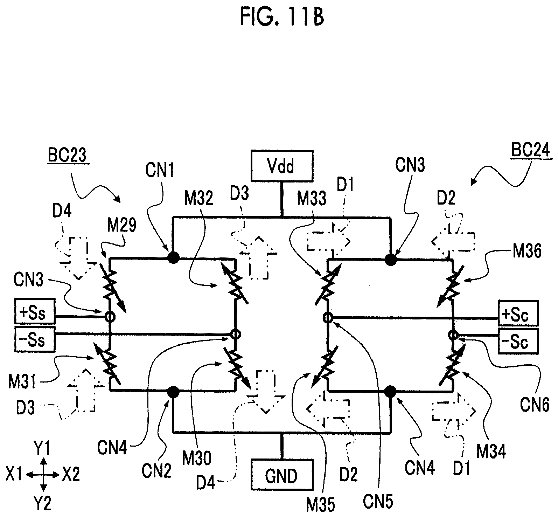

First, the element substrates 25 of the magnetic sensor 102 are manufactured by using a base substrate made of silicon or the like, and are constituted by the element substrates 25A and 25B each of which includes the plurality of magnetoresistive effect elements M formed on one surface side of the base substrate. As illustrated in Fig. 9, the element substrate 25A includes the first magnetic detection element group G21 provided with the eight (M21 to M28) magnetoresistive effect elements M, and the element substrate 25B includes the second magnetic detection element group G22 provided with the eight (M29 to M36) magnetoresistive effect elements M. In addition, each of the first magnetic detection element group G21 and the second magnetic detection element group G22 forms a bridge circuit (see Figs. 11A and 11B), which will be described later, by connecting the eight magnetoresistive effect elements M through the wiring patterns (not illustrated).

In the second embodiment of the present invention, as illustrated in Fig. 10A, the element substrate 25 is packaged so that the magnetic sensing surface which detects the magnetic field in the magnetoresistive effect element M, that is, one surface in which the magnetoresistive effect element M is formed is disposed at the center position in the thickness direction of the independent package body. Accordingly, even when the independent package bodies (the first sensor body S21 and the second sensor body S22) which are the same are inverted to be arranged in parallel as illustrated in Fig. 10B, only by disposing the first sensor body S21 and the second sensor body S22 to allow the heights in the thickness direction thereof to be aligned with each other, the magnetic sensing surface (first magnetic sensing surface 25p) of the magnetoresistive effect element M of the first magnetic detection element group G21 and the magnetic sensing surface (second magnetic sensing surface 25q) of the magnetoresistive effect element M of the second magnetic detection element group G22 can be formed on the same plane.

Here, the magnetoresistive effect element M used in the second embodiment of the present invention is a self-pinned magnetoresistive effect element M as in the first embodiment, and thus the detailed description of the magnetoresistive effect element M will be omitted.

As illustrated in Fig. 9, the first magnetic detection element group G21 (the second magnetic detection element group G22) which uses the self-pinned magnetoresistive effect elements M described above is configured by combining the magnetoresistive effect elements M having four different magnetization directions (the pinned magnetization direction of the fixed magnetic layer 2 or the sensitivity axis direction).

In addition, as illustrated in Fig. 8, one end portion of the first sensor body S21 and one end portion of the second sensor body S22 are disposed to oppose each other with a reference line (a third virtual line K23 that is parallel to the X-axis direction and passes between the first sensor body S21 and the second sensor body S22) interposed therebetween, and the first magnetic detection element group G21 and the second magnetic detection element group G22 are configured to be disposed so that the magnetization directions (the first direction D1, the second direction D2, the third direction D3, and the fourth direction D4) have line symmetry about the reference line (the third virtual line K23) as illustrated in Fig. 9. Accordingly, by disposing the magnet body MG10 to allow the center line of the single magnet body MG10 to be coincident with the reference line (the third virtual line K23), the first magnetic detection element group G21 and the second magnetic detection element group G22 are disposed at equivalent positions in left and right magnetic fields generated by the magnet body MG10 . Therefore, the detection value (the first detection value) from the detection signal from the first magnetic detection element group G21 and the detection value (the second detection value) from the detection signal from the second magnetic detection element group G22 can be obtained as equal output values.

Moreover, since the magnetoresistive effect elements M are of the self-pinned type, the magnetoresistive effect elements M of the first magnetic detection element group G21 and the second magnetic detection element group G22 can be manufactured on the same wafer, and two magnetoresistive effect elements M having a symmetrical relationship (one is in the first magnetic detection element group G21 and the other is in the second magnetic detection element group G22) can be formed at the same timing. Therefore, the first detection value and the second detection value can be obtained as equal output values.

Here, regarding the first magnetic detection element group G21 and the second magnetic detection element group G22 formed in the element substrates 25 (25A and 25B), bridge circuits will be simply described. Figs. 11A and 11B are circuit diagrams of the magnetoresistive effect elements M which are associated with the magnetic sensor 102 of the second embodiment of the present invention and are bridged, Fig. 11A is a bridge circuit of the first magnetic detection element group G21, and Fig. 11B is a bridge circuit of the second magnetic detection element group G22. In Figs. 11A and 11B, the sensitivity axis direction (magnetization direction) of each of the magnetoresistive effect elements M is illustrated.

As illustrated in Fig. 11A, the bridge circuit of the first magnetic detection element group G21 is configured to have a first bridge circuit BC21 using the four magnetoresistive effect elements M (M21, M22, M23, and M24) and a second bridge circuit BC22 using the four magnetoresistive effect elements M (M25, M26, M27, and M28).

As illustrated in Fig. 11B, the bridge circuit of the second magnetic detection element group G22 is configured to have a third bridge circuit BC23 using the four magnetoresistive effect elements M (M29, M30, M31, and M32) and a fourth bridge circuit BC24 using the four magnetoresistive effect elements M (M33, M34, M35, and M36).

First, as illustrated in Fig. 11A, the first bridge circuit BC21 is constituted by the magnetoresistive effect element M21 pinned along the fourth direction D4 (the Y2 direction shown in Fig. 9), the magnetoresistive effect element M22 pinned along the fourth direction D4, the magnetoresistive effect element M23 pinned along the third direction D3 (the Y1 direction shown in Fig. 9), and the magnetoresistive effect element M24 pinned along the third direction D3. In the first bridge circuit BC21 configured as described above, a predetermined potential difference is established between the first connection portion CN1 and the second connection portion CN2 (between the source Vdd and the ground GND), and two outputs (output signals Ss having inverted sine waves) corresponding to changes in temperature and external magnetic field are obtained by the third connection portion CN3 and the fourth connection portion CN4.

Next, as illustrated in Fig. 11A, the second bridge circuit BC22 is constituted by the magnetoresistive effect element M25 pinned along the first direction D1 (the X2 direction shown in Fig. 9), the magnetoresistive effect element M26 pinned along the first direction D1, the magnetoresistive effect element M27 pinned along the second direction D2 (the X1 direction shown in Fig. 9), and the magnetoresistive effect element M28 pinned along the second direction D2. In the second bridge circuit BC22 configured as described above, a predetermined potential difference is established between the third connection portion CN3 and the fourth connection portion CN4 (between the source Vdd and the ground GND), and two outputs (output signals Ss having inverted cosine waves) corresponding to changes in temperature and external magnetic field are obtained by the fifth connection portion CN5 and the sixth connection portion CN6.

The output values from the first magnetic detection element group G21 having the first and second bridge circuits BC21 and BC22 configured as described above are four output values which are out of phase with each other and have different waveforms, and the four output values are transmitted to the first control unit C21.

On the other hand, the third and fourth bridge circuits BC23 and BC24 of the second magnetic detection element group G22 are configured to be the same as the first and second bridge circuits BC21 and BC22 of the first magnetic detection element group G21, respectively, and the magnetoresistive effect elements M in the first and second bridge circuits BC21 and BC22 are substituted with the magnetoresistive effect elements M in point symmetry. That is, as illustrated in Fig. 11B, the magnetoresistive effect element M21 is substituted with the magnetoresistive effect element M29, the magnetoresistive effect element M22 is substituted with the magnetoresistive effect element M30, the magnetoresistive effect element M23 is substituted with the magnetoresistive effect element M31, the magnetoresistive effect element M24 is substituted with the magnetoresistive effect element M32, the magnetoresistive effect element M25 is substituted with the magnetoresistive effect element M33, the magnetoresistive effect element M26 is substituted with the magnetoresistive effect element M34, the magnetoresistive effect element M27 is substituted with the magnetoresistive effect element M35, and the magnetoresistive effect element M28 is substituted with the magnetoresistive effect element M36.

Accordingly, the output values from the second magnetic detection element group G22 having the third and fourth bridge circuits BC23 and BC24 are four output values which are out of phase with each other and have different waveforms like the output values from the first magnetic detection element group G21, and furthermore, equal output values are transmitted to the second control unit C22. Therefore, even in a case where any of the system of the first magnetic detection element group G21 and the system of the second magnetic detection element group G22 has a problem, the magnetic sensor 102 can provide accurate output information to an external device.

Next, the first control unit C21 and the second control unit C22 of the magnetic sensor 102 will be described. As in the first embodiment, the first control unit C21 and the second control unit C22 are configured by using an integrated circuit (IC) and process the detection signals from the first magnetic detection element group G21 and the second magnetic detection element group G22. In addition, the first control unit C21 and the second control unit C22 output the processed information to the rotational angle detection device as output signals (output information) via the terminals T7.

In the first embodiment of the present invention, the two first and second control units C21 and C22 are separately provided as two chips and are separately packaged. Therefore, for example, even when any one of the first and second control units C21 and C22 has a problem, the other can output an output signal. Accordingly, the magnetic sensor 102 having high reliability can be provided.

Last, the circuit boards P29 (P29A and P29B) of the magnetic sensor 102 will be described. As in the first embodiment, the circuit board P29 of the magnetic sensor 102 uses a double-sided printed wiring board (PWB) which is generally used. As illustrated in Fig. 8, the capacitors CD, the element substrate 25A (the element substrate 25B), and the first control unit C21 (the second control unit C22) are mounted on one side of the circuit board P29A (the circuit board P29B), and the terminals T7 are mounted on the other side of the circuit board P29A. In Fig. 8, detailed wiring patterns are omitted.

The effects of the magnetic sensor 102 of the second embodiment of the present invention configured as described above will be described below in summary.

The magnetic sensor 102 of the second embodiment of the present invention includes the first magnetic detection element group G21 and the second magnetic detection element group G22 each of which includes the plurality of magnetoresistive effect elements M, and the plurality of magnetoresistive effect elements M of the first magnetic detection element group G21 and the plurality of magnetoresistive effect elements M of the second magnetic detection element group G22 are arranged so that the pinned magnetization directions thereof are symmetrical. Accordingly, the first magnetic detection element group G21 and the second magnetic detection element group G22 are disposed at equivalent positions in the magnetic field generated by the magnet body MG10. Therefore, the detection value (the first detection value) from the detection signal from the first magnetic detection element group G21 and the detection value (the second detection value) from the detection signal from the second magnetic detection element group G22 can be obtained as equal output values. Moreover, since the magnetoresistive effect elements M are of the self-pinned type, the magnetoresistive effect elements M of the first magnetic detection element group G21 and the second magnetic detection element group G22 can be manufactured on the same wafer, and two magnetoresistive effect elements M having a symmetrical relationship (one is in the first magnetic detection element group G21 and the other is in the second magnetic detection element group G22) can be formed at the same timing. Therefore, the first detection value and the second detection value can be obtained as equal output values. Accordingly, the magnetic sensor 102 which allow pieces of output information obtained from the two output values to be equal to each other can be provided.

In addition, the first sensor body S21 and the second sensor body S22 having the same configuration sealed in the single independent package body are disposed so as to allow one end portions of the independent package bodies to oppose each other and are configured such that the magnetization directions of the plurality of magnetoresistive effect elements M of the first magnetic detection element group G21 and the plurality of magnetoresistive effect elements M of the second magnetic detection element group G22 have line symmetry. Therefore, sensor bodies having a single configuration may be manufactured and inverted to be used as the first sensor body S21 and the second sensor body S22. Accordingly, the magnetic sensor 102 can be easily manufactured.

In addition, since the magnetic sensing surfaces of the magnetoresistive effect elements M in the first magnetic detection element group G21 and the second magnetic detection element group G22 are disposed at the center position in the thickness direction of the independent package body, only by disposing the first sensor body S21 and the second sensor body S22 to allow the heights in the thickness direction thereof to be aligned with each other, the magnetic sensing surface of the magnetoresistive effect elements M of the first magnetic detection element group G21 and the magnetic sensing surface of the magnetoresistive effect elements M of the second magnetic detection element group G22 can be formed on the same plane. Accordingly, the magnetic sensor 102 can be easily manufactured.

In addition, since the protrusions 26 which are directed toward the outside are included in the other end portions of the first sensor body S21 and the second sensor body S22, one end portion in which each of the first magnetic detection element group G21 and the second magnetic detection element group G22 is provided can be reliably recognized. Accordingly, the magnetic sensor 102 can be easily manufactured to allow one end portions thereof to oppose each other without failure.

The present invention is not limited to the above-described embodiments, and for example, can be modified as follows. These embodiments belong to the technical scope of the present invention.

### Modification Example 1

In the first embodiment, the bridge circuits (the first and second bridge circuits BC1 and BC2) of the first magnetic detection element group G11 and the bridge circuits (the third and fourth bridge circuits BC3 and BC4) of the second magnetic detection element group G12 are configured by combining the magnetoresistive effect elements M which are disposed so that the magnetization directions thereof have point symmetry about the reference point (center point). However, the configuration is not limited thereto. For example, the bridge circuits may also be configured by combining the magnetoresistive effect elements M which are disposed so that the magnetization directions thereof have line symmetry about a reference line.

### Modification Example 2

In the first embodiment, the configuration in which the two first and second control units C11 and C12 are provided to be appropriately separated is provided. However, the configuration is not limited thereto, and a configuration in which the first and second control units C11 and C12 are provided in a single chip may also be provided.

### Modification Example 3

In the second embodiment, the configuration in which the protrusions 26 are provided in the other ends of the independent package bodies is provided. However, the protrusions may also be provided in any portions as long as the two sensor bodies do not interfere with each other when arranged in parallel. For example, the protrusions 26 may also be provided on the terminal T7 side or on the side opposite to the terminal T7. In addition, the protrusions 26 may also be provided on the side of one end portions.

### Modification Example 4

In the second embodiment, the protrusions 26 are formed of a metallic thin plate and are formed simultaneously with the terminals T7 . However, the protrusions 26 are not limited thereto. For example, protrusions may also be formed by providing convex shapes made of a resin in the external shape of the resin package. Modification Example 5

In the embodiments, the plurality of magnetization directions which are different from each other include the four directions (the first, second, third, and fourth directions D1, D2, D3, and D4) which are opposite in the X-axis direction and the Y-axis direction. However, the magnetization directions are not limited thereto. For example, the magnetization directions may be two opposite directions, three directions shifted by 120°, or six directions shifted by 60°.

### Modification Example 6

In the embodiment, the bridge circuits are configured by using four full bridge circuits. However, the bridge circuits are not limited thereto. For example, the bridge circuits may be two full bridge circuits or may be a combination of half-bridge circuits.

The present invention is not limited to the embodiments and can be appropriately changed without departing from the scope of the present invention.

It should be understood by those skilled in the art that various modifications, combinations, sub-combinations and alterations may occur depending on design requirements and other factors insofar as they are within the scope of the appended claims of the equivalents thereof.

## Claims

1. A magnetic sensor (101) comprising:
a first magnetic detection element group (G11) and a second magnetic detection element group (G12) each of which including a plurality of magnetoresistive effect elements (M) each in which a fixed magnetic layer (2) and a free magnetic layer (4) are laminated with a non-magnetic material layer (3) interposed therebetween; and
a first control unit (C11) and a second control unit (C12) configured to respectively process detection signals detected from a magnetic field by the magnetoresistive effect elements (M) of the first magnetic detection element group (G11) and the second magnetic detection element group (G12),
wherein the fixed magnetic layer (2) is of a self-pinned type in which a first magnetic layer (12) and a second magnetic layer (22) are laminated with a non-magnetic intermediate layer (42) interposed therebetween and magnetization directions (D1, D2, D3, and D4) of the first magnetic layer (12) and the second magnetic layer (22) are fixed to be antiparallel to each other, and
pinned magnetization directions of at least two magnetoresistive effect elements (M) in the first magnetic detection element group (G11) and the second magnetic detection element group (G12) are different from each other, and the plurality of magnetoresistive effect elements (M) of the first magnetic detection element group (G11) and the plurality of magnetoresistive effect elements (M) of the second magnetic detection element group (G12) are arranged so that the magnetization directions (D1, D2, D3, and D4) thereof are symmetrical,
wherein the first magnetic detection element group (G11) and the second magnetic detection element group (G12) are formed on a single element substrate (15), and **characterised in that** the plurality of magnetoresistive effect elements (M) of the first magnetic detection element group (G11) and the plurality of magnetoresistive effect elements (M) of the second magnetic detection element group (G12) are divided by a first virtual line K1 parallel to the Y-axis direction into combinations each of which includes four different magnetization directions and are arranged so that the magnetization directions (D1, D2, D3, and D4) thereof have point symmetry about a reference point on the element substrate (15), wherein the first magnetic detection element group (G11) and the second magnetic detection element group (G12) are configured to be disposed so that the magnetization directions have line symmetry about a second virtual line K2 that is parallel to the X-axis direction and the point of symmetry is the point of intersection between the first virtual line K1 and the second virtual line K2.

2. The magnetic sensor according to claim 1,
wherein the first magnetic detection element group (G11), the second magnetic detection element group (G12), the first control unit (C11), and the second control unit (C12) are sealed in a single composite package body, and
wherein the first control unit (C11) and the second control unit (C12) are disposed with the first magnetic detection element group (G11) and the second magnetic detection element group (G12) interposed therebetween.

3. A magnetic sensor (101) comprising:
a first magnetic detection element group (G11) and a second magnetic detection element group (G12) each of which including a plurality of magnetoresistive effect elements (M) each in which a fixed magnetic layer (2) and a free magnetic layer (4) are laminated with a non-magnetic material layer (3) interposed therebetween; and
a first control unit (C11) and a second control unit (C12) configured to respectively process detection signals detected from a magnetic field by the magnetoresistive effect elements (M) of the first magnetic detection element group (G11) and the second magnetic detection element group (G12),
wherein the fixed magnetic layer (2) is of a self-pinned type in which a first magnetic layer (12) and a second magnetic layer (22) are laminated with a non-magnetic intermediate layer (42) interposed therebetween and magnetization directions (D1, D2, D3, and D4) of the first magnetic layer (12) and the second magnetic layer (22) are fixed to be antiparallel to each other,
wherein pinned magnetization directions of at least two magnetoresistive effect elements (M) in the first magnetic detection element group (G11) and the second magnetic detection element group (G12) are different from each other, and the plurality of magnetoresistive effect elements (M) of the first magnetic detection element group (G11) and the plurality of magnetoresistive effect elements (M) of the second magnetic detection element group (G12) are arranged so that the magnetization directions (D1, D2, D3, and D4) thereof are symmetrical,
wherein the first magnetic detection element group (G11) and the first control unit (C11) are sealed in a single independent package body,
wherein the first magnetic detection element group (G11) includes a first sensor body (S21) disposed in one end portion of the independent package body, and a second sensor body (S22) having the same structure as that of the first sensor body (S21),
wherein the first magnetic detection element group (G11) sealed in the second sensor body (S22) is the same as the second magnetic detection element group (G12), and the first control unit (S21) is the same as the second control unit (C12),
wherein one end portion of the first sensor body (S21) and one end portion of the second sensor body (S22) are disposed to oppose each other with a reference line interposed therebetween, and **characterised in that** the magnetization directions (D1, D2, D3, and D4) of the plurality of magnetoresistive effect elements (M) of the first magnetic detection element group (G11) and the magnetization directions (D1, D2, D3, and D4) of the plurality of magnetoresistive effect elements (M) of the second magnetic detection element group (G12) are fixed to have line symmetry about the reference line,
wherein a magnetic sensing surface detecting the magnetic fields of the magnetoresistive effect elements (M) in each of the first magnetic detection element group (G11) and the second magnetic detection element group (G12) is disposed at a center position in a thickness direction of the independent package body, and
wherein the magnetic sensor further comprises a protrusion (26) directed toward the outside in a planar direction from the other end portion of the independent package body.

## Patentansprüche

1. Magnetsensor (101), aufweisend:
eine erste magnetische Detektionselementgruppe (G11) und eine zweite magnetische Detektionselementgruppe (G12), die jeweils eine Mehrzahl von Magnetowiderstandseffekt-Elementen (M) beinhalten, bei denen jeweils eine fixierte magnetische Schicht (2) und eine freie magnetische Schicht (4) unter Zwischenanordnung einer nicht-magnetischen Materialschicht (3) laminiert sind; und
eine erste Steuereinheit (C11) und eine zweite Steuereinheit (C12), die dazu ausgebildet sind, jeweils Detektionssignale zu verarbeiten, die durch die Magnetowiderstandseffekt-Elemente (M) der ersten magnetischen Detektionselementgruppe (G11) und der zweiten magnetischen Detektionselementgruppe (G12) von einem Magnetfeld detektiert werden,
wobei die fixierte magnetische Schicht (2) vom selbstgepinnten Typ ist, wobei eine erste magnetische Schicht (12) und eine zweite magnetische Schicht (22) unter Zwischenanordnung einer nicht-magnetischen Zwischenschicht (42) laminiert sind und Magnetisierungsrichtungen (D1, D2, D3 und D4) der ersten magnetischen Schicht (12) und der zweiten magnetischen Schicht (22) antiparallel zueinander fixiert sind, und
wobei gepinnte Magnetisierungsrichtungen von mindestens zwei Magnetowiderstandseffekt-Elementen (M) in der ersten magnetischen Detektionselementgruppe (G11) und der zweiten magnetischen Detektionselementgruppe (G12) voneinander verschieden sind, und die Mehrzahl von Magnetowiderstandseffekt-Elementen (M) der ersten magnetischen Detektionselementgruppe (G11) und die Mehrzahl von Magnetowiderstandseffekt-Elementen (M) der zweiten magnetischen Detektionselementgruppe (G12) derart angeordnet sind, dass ihre Magnetisierungsrichtungen (D1, D2, D3 und D4) symmetrisch sind,
wobei die erste magnetische Detektionselementgruppe (G11) und die zweite magnetische Detektionselementgruppe (G12) auf einem einzigen Elementsubstrat (15) gebildet sind, und
**dadurch gekennzeichnet, dass** die Mehrzahl von Magnetowiderstandseffekt-Elementen (M) der ersten magnetischen Detektionselementgruppe (G11) und die Mehrzahl von Magnetowiderstandseffekt-Elementen (M) der zweiten magnetischen Detektionselementgruppe (G12) durch eine zu der Y-Achsen-Richtung parallele erste virtuelle Linie K1 in Kombinationen geteilt sind, die jeweils vier verschiedene Magnetisierungsrichtungen beinhalten, sowie derart angeordnet sind, dass ihre Magnetisierungsrichtungen (D1, D2, D3 und D4) punktsymmetrisch um einen Referenzpunkt auf dem Elementsubstrat (15) sind,
wobei die erste magnetische Detektionselementgruppe (G11) und die zweite magnetische Detektionselementgruppe (G12) für eine derartige Anordnung ausgebildet sind, dass die Magnetisierungsrichtungen liniensymmetrisch um eine zweite virtuelle Linie K2 sind, die parallel zu der X-AchsenRichtung ist, und der Symmetriepunkt der Schnittpunkt zwischen der ersten virtuellen Linie K1 und der zweiten virtuellen Linie K2 ist.

2. Magnetsensor nach Anspruch 1,
wobei die erste magnetische Detektionselementgruppe (G11), die zweite magnetische Detektionselementgruppe (G12), die erste Steuereinheit (C11) und die zweite Steuereinheit (C12) in einen einzigen Verbundgehäusekörper eingekapselt sind, und
wobei die erste Steuereinheit (C11) und die zweite Steuereinheit (C12) unter Zwischenanordnung der ersten magnetischen Detektionselementgruppe (G11) und der zweiten magnetischen Detektionselementgruppe (G12) angeordnet sind.

3. Magnetsensor (101), aufweisend:
eine erste magnetische Detektionselementgruppe (G11) und eine zweite magnetische Detektionselementgruppe (G12), die jeweils eine Mehrzahl von Magnetowiderstandseffekt-Elementen (M) beinhalten, bei denen jeweils eine fixierte magnetische Schicht (2) und eine freie magnetische Schicht (4) unter Zwischenanordnung einer nicht-magnetischen Materialschicht (3) laminiert sind; und
eine erste Steuereinheit (C11) und eine zweite Steuereinheit (C12), die dazu ausgebildet sind, jeweils Detektionssignale zu verarbeiten, die durch die Magnetowiderstandseffekt-Elemente (M) der ersten magnetischen Detektionselementgruppe (G11) und der zweiten magnetischen Detektionselementgruppe (G12) von einem Magnetfeld detektiert werden,
wobei die fixierte magnetische Schicht (2) vom selbstgepinnten Typ ist, wobei eine erste magnetische Schicht (12) und eine zweite magnetische Schicht (22) unter Zwischenanordnung einer nicht-magnetischen Zwischenschicht (42) laminiert sind und Magnetisierungsrichtungen (D1, D2, D3 und D4) der ersten magnetischen Schicht (12) und der zweiten magnetischen Schicht (22) antiparallel zueinander fixiert sind, und
wobei gepinnte Magnetisierungsrichtungen von mindestens zwei Magnetowiderstandseffekt-Elementen (M) in der ersten magnetischen Detektionselementgruppe (G11) und der zweiten magnetischen Detektionselementgruppe (G12) voneinander verschieden sind, und die Mehrzahl von Magnetowiderstandseffekt-Elementen (M) der ersten magnetischen Detektionselementgruppe (G11) und die Mehrzahl von Magnetowiderstandseffekt-Elementen (M) der zweiten magnetischen Detektionselementgruppe (G12) derart angeordnet sind, dass ihre Magnetisierungsrichtungen (D1, D2, D3 und D4) symmetrisch sind,
wobei die erste magnetische Detektionselementgruppe (G11) und die erste Steuereinheit (C11) in einen einzigen unabhängigen Gehäusekörper eingekapselt sind,
wobei die erste magnetische Detektionselementgruppe (G11) einen ersten Sensorkörper (S21) aufweist, der in dem einen Endbereich des unabhängigen Gehäusekörpers angeordnet ist, sowie einen zweiten Sensorkörper (S22) aufweist, der die gleiche Konstruktion wie der erste Sensorkörper (S21) aufweist,
wobei die in den zweiten Sensorkörper (S22) eingekapselte erste magnetische Detektionselementgruppe (G11) mit der zweiten magnetischen Detektionselementgruppe (G12) identisch ist und die erste Steuereinheit (S21) mit der zweiten Steuereinheit (C12) identisch ist,
wobei der eine Endbereich des ersten Sensorkörpers (S21) und der eine Endbereich des zweiten Sensorkörpers (S22) unter Zwischenanordnung einer Referenzlinie einander gegenüberliegend angeordnet sind, und
**dadurch gekennzeichnet,**
**dass** die Magnetisierungsrichtungen (D1, D2, D3 und D4) der Mehrzahl der Magnetowiderstandseffekt-Elemente (M) der ersten magnetischen Detektionselementgruppe (G11) und die Magnetisierungsrichtungen (D1, D2, D3 und D4) der Mehrzahl der Magnetowiderstandseffekt-Elemente (M) der zweiten magnetischen Detektionselementgruppe (G12) derart fixiert sind, dass sie liniensymmetrisch um die Referenzlinie sind,
wobei eine magnetische Erfassungsfläche, die die Magnetfelder der Magnetowiderstandseffekt-Elemente (M) in der jeweiligen ersten magnetischen Detektionselementgruppe (G11) und der zweiten magnetischen Detektionselementgruppe (G12) detektiert, in einer Dickenrichtung des unabhängigen Gehäusekörpers in einer zentralen Position angeordnet ist, und
wobei der Magnetsensor ferner einen Vorsprung (26) aufweist, der von dem anderen Endbereich des unabhängigen Gehäusekörpers in einer planaren Richtung nach außen gerichtet ist.

## Revendications

1. Capteur magnétique (101) comprenant :
un premier groupe d'éléments de détection magnétique (G11) et un second groupe d'éléments de détection magnétique (G12), dont chacun comprend une pluralité d'éléments à effet magnétorésistif (M) dans chacun desquels une couche magnétique fixe (2) et une couche magnétique libre (4) sont stratifiées avec une couche de matériau non magnétique (3) interposée entre elles ; et
une première unité de commande (C11) et une seconde unité de commande (C12) configurées pour traiter respectivement des signaux de détection obtenus par détection d'un champ magnétique par les éléments à effet magnétorésistif (M) du premier groupe d'éléments de détection magnétique (G11) et du second groupe d'éléments de détection magnétique (G12),
dans lequel la couche magnétique fixe (2) est d'un type auto-piégé dans lequel une première couche magnétique (12) et une seconde couche magnétique (22) sont stratifiées avec une couche intermédiaire non magnétique (42) interposée entre elles et les directions d'aimantation (D1, D2, D3 et D4) de la première couche magnétique (12) et de la seconde couche magnétique (22) sont fixées pour être antiparallèles l'une à l'autre, et
les directions d'aimantation piégées d'au moins deux éléments à effet magnétorésistif (M) dans le premier groupe d'éléments de détection magnétique (G11) et le second groupe d'éléments de détection magnétique (G12) sont différentes l'une de l'autre, et la pluralité d'éléments à effet magnétorésistif (M) du premier groupe d'éléments de détection magnétique (G11) et la pluralité d'éléments à effet magnétorésistif (M) du second groupe d'éléments de détection magnétique (G12) sont agencés de manière que leurs directions d'aimantation (D1, D2, D3 et D4) soient symétriques,
dans lequel le premier groupe d'éléments de détection magnétique (G11) et le second groupe d'éléments de détection magnétique (G12) sont formés sur un unique substrat d'éléments (15), et
**caractérisé en ce que** la pluralité d'éléments à effet magnétorésistif (M) du premier groupe d'éléments de détection magnétique (G11) et la pluralité d'éléments à effet magnétorésistif (M) du second groupe d'éléments de détection magnétique (G12) sont divisés, par une première ligne virtuelle K1 parallèle à la direction d'axe Y, en des combinaisons dont chacune comprend quatre directions d'aimantation différentes, et sont agencés de manière que leurs directions d'aimantation (D1, D2, D3 et D4) présentent une symétrie centrale autour d'un point de référence sur le substrat d'éléments (15),
dans lequel le premier groupe d'éléments de détection magnétique (G11) et le second groupe d'éléments de détection magnétique (G12) sont configurés pour être disposés de manière que les directions d'aimantation présentent une symétrie axiale autour d'une seconde ligne virtuelle K2 qui est parallèle à la direction d'axe X, et le centre de symétrie est le point d'intersection entre la première ligne virtuelle K1 et la seconde ligne virtuelle K2.

2. Capteur magnétique selon la revendication 1,
dans lequel le premier groupe d'éléments de détection magnétique (G11), le second groupe d'éléments de détection magnétique (G12), la première unité de commande (C11) et la seconde unité de commande (C12) sont enfermés hermétiquement dans un unique corps de boîtier composite, et
dans lequel la première unité de commande (C11) et la seconde unité de commande (C12) sont disposées avec le premier groupe d'éléments de détection magnétique (G11) et le second groupe d'éléments de détection magnétique (G12) interposés entre elles.

3. Capteur magnétique (101) comprenant :
un premier groupe d'éléments de détection magnétique (G11) et un second groupe d'éléments de détection magnétique (G12), dont chacun comprend une pluralité d'éléments à effet magnétorésistif (M) dans chacun desquels une couche magnétique fixe (2) et une couche magnétique libre (4) sont stratifiées avec une couche de matériau non magnétique (3) interposée entre elles ; et
une première unité de commande (C11) et une seconde unité de commande (C12) configurées pour traiter respectivement des signaux de détection obtenus par détection d'un champ magnétique par les éléments à effet magnétorésistif (M) du premier groupe d'éléments de détection magnétique (G11) et du second groupe d'éléments de détection magnétique (G12),
dans lequel la couche magnétique fixe (2) est d'un type auto-piégé dans lequel une première couche magnétique (12) et une seconde couche magnétique (22) sont stratifiées avec une couche intermédiaire non magnétique (42) interposée entre elles et les directions d'aimantation (D1, D2, D3 et D4) de la première couche magnétique (12) et de la seconde couche magnétique (22) sont fixées pour être antiparallèles l'une à l'autre,
dans lequel les directions d'aimantation piégées d'au moins deux éléments à effet magnétorésistif (M) dans le premier groupe d'éléments de détection magnétique (G11) et le second groupe d'éléments de détection magnétique (G12) sont différentes l'une de l'autre, et la pluralité d'éléments à effet magnétorésistif (M) du premier groupe d'éléments de détection magnétique (G11) et la pluralité d'éléments à effet magnétorésistif (M) du second groupe d'éléments de détection magnétique (G12) sont agencés de manière que leurs directions d'aimantation (D1, D2, D3 et D4) soient symétriques,
dans lequel le premier groupe d'éléments de détection magnétique (G11) et le second groupe d'éléments de détection magnétique (G12) sont enfermés hermétiquement dans un unique corps de boîtier indépendant,
dans lequel le premier groupe d'éléments de détection magnétique (G11) comporte un premier corps de capteur (S21) disposé dans une partie d'extrémité du corps de boîtier indépendant, et un second corps de capteur (S22) possédant la même structure que le premier corps de capteur (S21),
dans lequel le premier groupe d'éléments de détection magnétique (G11) enfermé hermétiquement dans le second corps de capteur (S22) est le même que le second groupe d'éléments de détection magnétique (G12), et la première unité de commande (S21) est la même que la seconde unité de commande (C12),
dans lequel une partie d'extrémité du premier corps de capteur (S21) et une partie d'extrémité du second corps de capteur (S22) sont disposées pour se faire face avec une ligne de référence interposée entre elles, et
**caractérisé en ce que** les directions d'aimantation (D1, D2, D3 et D4) de la pluralité d'éléments à effet magnétorésistif (M) du premier groupe d'éléments de détection magnétique (G11) et les directions d'aimantation (D1, D2, D3 et D4) de la pluralité d'éléments à effet magnétorésistif (M) du second groupe d'éléments de détection magnétique (G12) sont fixées pour présenter une symétrie axiale autour de la ligne de référence,
dans lequel une surface de détection magnétique, qui détecte les champs magnétiques, des éléments à effet magnétorésistif (M) dans chacun du premier groupe d'éléments de détection magnétique (G11) et du second groupe d'éléments de détection magnétique (G12) est disposée au niveau d'une position centrale dans une direction d'épaisseur du corps de boîtier indépendant, et
dans lequel le capteur magnétique comprend en outre une protubérance (26) dirigée vers l'extérieur dans une direction plane à partir de l'autre partie d'extrémité du corps de boîtier indépendant.
